Europäisches Patentamt

European Patent Office

Office européen des brevets

(19)

(11) Veröffentlichungsnummer: **0 023 241**
**B1**

# (12) EUROPÄISCHE PATENTSCHRIFT

(45) Veröffentlichungstag der Patentschrift:
**13.07.88**

(21) Anmeldenummer: **80101446.5**

(22) Anmeldetag: **19.03.80**

(51) Int. Cl.⁴: **H 01 L 23/52,** H 01 L 21/90,
H 01 L 29/62

(54) **Niederohmige Leitung für eine Halbleitervorrichtung und Verfahren zu deren Herstellung.**

(30) Priorität: **30.03.79 DE 2912858**

(43) Veröffentlichungstag der Anmeldung:
**04.02.81 Patentblatt 81/5**

(45) Bekanntmachung des Hinweises auf die Patenterteilung:
**13.07.88 Patentblatt 88/28**

(84) Benannte Vertragsstaaten:
**FR GB NL**

(56) Entgegenhaltungen:
**CH - A - 534 939**
**DE - A - 2 726 004**
**FR - A - 2 380 620**
**US - A - 4 060 796**

**IBM TECHNICAL DISCLOSURE BULLETIN, Band 21, Nr. 9, Februar 1979, Seiten 3828-3831, New York, USA V.L. RIDEOUT: "Double polysilicon dynamic memory cell with polysilicon bit line"**

(73) Patentinhaber: **Siemens Aktiengesellschaft Berlin und München, Wittelsbacherplatz 2, D-8000 München 2 (DE)**

(72) Erfinder: **Horninger, Karlheinrich, Dr., Riederinger Strasse 9, D-8011 Eglharting (DE)**
Erfinder: **Schwabe, Ulrich, Dr., Grünwalder Strasse 40, D-8000 München 90 (DE)**

## Beschreibung

Die Erfindung bezieht sich auf eine niederohmige Leitung nach dem Oberbegriff des Patentanspruchs 1 und auf ein Verfahren zu ihrer Herstellung.

Solche Leitungen werden beispielsweise als Bitleitungen für Halbleiterspeicher verwendet. Dabei tritt jedoch das Problem auf, dass Bitleitungen von Speichern mit grösserer Speicherkapazität im allgemeinen so lang sind, dass infolge des Leitungswiderstandes von etwa 20 bis 30 Ohm/Quadrat und der Leitungskapazität beim Ein- und Auslesen der zu speichernden Informationen Verzögerungszeiten in Kauf genommen werden müssen, die die Zugriffszeit des Speichers mitbestimmen.

Aus dem IBM Techn. Discl. Bull., Vol. 21, No. 9, Febr. 1979, Seiten 3828–3831 ist eine Bitleitung für einen auf einem Halbleiterkörper integrierten Halbleiterspeicher bekannt, die aus polykristallinem Silizium besteht. Sie verläuft hauptsächlich oberhalb einer dicken, den Halbleiterkörper bedeckenden Feldoxidschicht und kontaktiert eine Mehrzahl von oberflächenseitig in den Halbleiterkörper eingefügten, entgegengesetzt zu diesem dotierten Halbleitergebieten, welche sich jeweils bis unter die Ränder von den einzelnen Speicherzellen zugeordneten Transfergates erstrecken. Die Transfergates überdecken dabei die Halbleiterbereiche zwischen den dotierten Halbleitergebieten und den einzelnen Speicherelektroden. Die Kontaktierung zwischen der Bitleitung und den dotierten Halbleitergebieten erfolgt lediglich lokal, d.h. in den durch die lateralen Abmessungen der dotierten Halbleitergebiete bestimmten Halbleiterbereichen, so dass die dotierten Halbleitergebiete auch als vergrabene Bitleitungskontakte aufgefasst werden können. Ausserhalb derselben ist die Bitleitung durch die Feldoxidschicht von der Grenzfläche des Halbleiterkörpers getrennt, was dazu führt, dass die Leitungskapazität der Bitleitung klein gehalten werden kann, ohne dass jedoch hierdurch der ohmsche Widerstand der Bitleitung wesentlich beeinflusst wird.

Aus der genannten Druckschrift ist auch ein Verfahren zur Herstellung einer niederohmigen Leitung bekannt, bei dem ein dotierter Halbleiterkörper an einer Grenzfläche mit einer elektrisch isolierenden Schicht bedeckt wird, diese Schicht mit einem Kontaktloch versehen wird, dann auf der elektrisch isolierenden Schicht eine Belegung aus polykristallinem Silizium aufgebracht wird, die Belegung einem Dotierungsvorgang ausgesetzt wird, bei dem im Bereich des Kontaktloches Dotierungsstoffe durch die Belegung in den Halbleiterkörper eindringen und das zu diesem entgegengesetzt dotierte Gebiet erzeugen, und schliesslich aus der Belegung durch fotolithographische Schritte der kontaktierende Streifen geformt wird. Bei einer in dieser Weise hergestellten Bitleitung ist die Leitungskapazität geringer als bei den herkömmlichen in den Halbleiterkörper eindiffundierten Bitleitungen, ohne dass jedoch der ohmsche Widerstand hierdurch wesentlich reduziert werden würde.

Der Erfindung liegt die Aufgabe zugrunde, eine Leitung der eingangs genannten Art anzugeben, die einen möglichst geringen ohmschen Widerstand aufweist. Das wird erfindungsgemäss durch die im kennzeichnenden Teil des Patentanspruchs 1 angegebenen Massnahmen erreicht.

Der mit der Erfindung erzielbare Vorteil besteht insbesondere darin, dass der Widerstand der aus dem entgegengesetzt dotierten Gebiet und dem kontaktierenden Streifen gebildeten Doppelleitungsstruktur wesentlich kleiner ist als der der herkömmlichen diffundierten Leitungen. Anspruch 2 gibt eine Weiterbildung des Erfindungsgedankens an, bei der ein Transfergate neben der niederohmigen Leitung angeordnet ist, das in seiner lateralen Position gegenüber dem Leitungsrand selbstjustiert ist. Die Ansprüche 3 und 4 betreffen vorteilhafte Anwendungen der erfindungsgemässen Leitung, während die Ansprüche 5 und 6 Verfahren zur Herstellung derselben angeben.

Die Erfindung wird nachfolgend anhand der Zeichnung näher erläutert. Dabei zeigt:

Fig. 1 eine Draufsicht auf eine erfindungsgemäss ausgebildete, niederohmige Leitung,

Fig. 2 einen Querschnitt durch die Leitung nach Fig. 1, und

Fig. 3 eine Draufsicht auf mehrere, mit erfindungsgemäss ausgebildeten Leitungen angesteuerte Ein-Transistor-Speicherzellen.

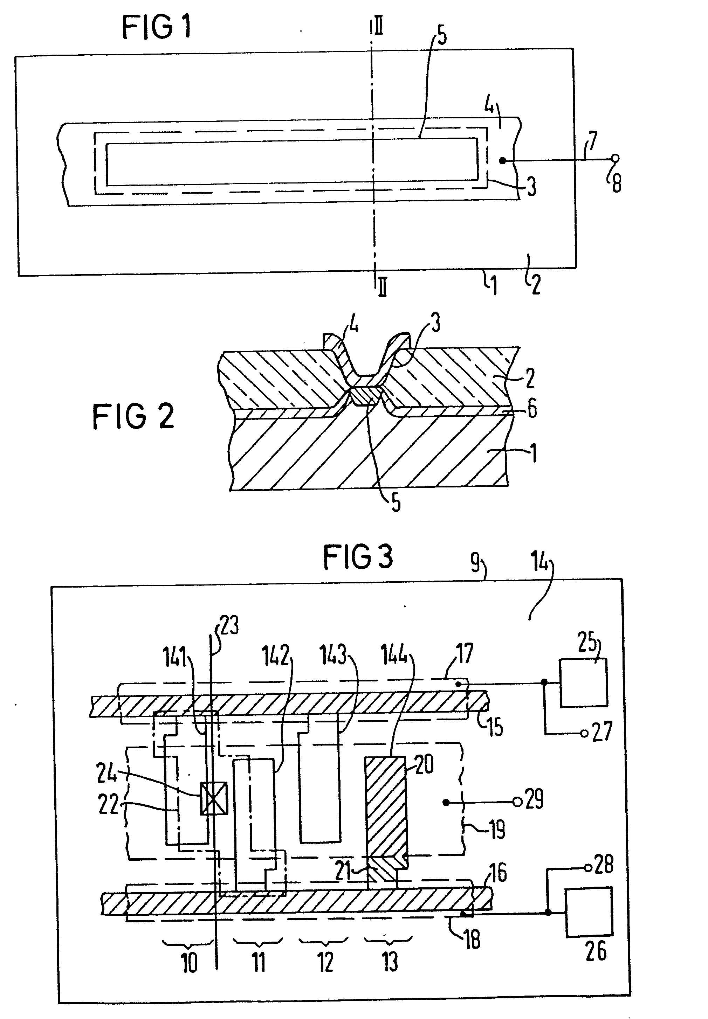

In Fig. 1 ist ein hochdotierter monokristalliner Halbleiterkörper 1 dargestellt, der auf seiner parallel zur Zeichenebene liegenden Begrenzungsfläche mit einer elektrisch isolierenden Schicht 2 abgedeckt ist. Der Halbleiterkörper 1 besteht z.B. aus p-dotiertem Silizium, während die isolierende Schicht vorzugsweise aus $SiO_2$ gebildet ist. Mit 3 ist ein streifenförmiges Kontaktloch bezeichnet, das aus der Schicht 2 ausgeätzt ist. Ein auf der isolierenden Schicht 2 aufgebrachter Streifen 4 aus hochdotiertem, polykristallinen Silizium, dessen laterale Begrenzungen in Fig. 1 durch eine ausgezogene Linie angedeutet sind, liegt innerhalb des Kontaktloches 3 der Grenzfläche des Halbleiterkörpers 1 unmittelbar an. Von der Berührungsfläche dieser beiden Teile ausgehend, erstreckt sich ein entgegengesetzt zu dem Halbleiterkörper 1 dotiertes, im vorliegenden Fall also $n^+$-leitendes streifenförmiges Halbleitergebiet 5 parallel zur Grenzfläche, dessen laterale Begrenzung ebenfalls durch eine ausgezogene Linie gekennzeichnet ist.

Fig. 2 zeigt einen Querschnitt entlang der Linie II–II von Fig. 1. Neben dem Halbleiterkörper 1, der als Dickschicht (Feldoxidschicht) ausgebildeten Schicht 2, dem die Grenzfläche von 1 kontaktierenden Streifen 4 und dem umdotierten Halbleitergebiet 5 ist unterhalb der Dickschicht 2 eine der Grenzfläche des Halbleiterkörpers 1 unmittelbar benachbarte Zone 6 erkennbar, die stärker dotiert ist als der Halbleiterkörper 1, jedoch den gleichen Leitfähigkeitstyp aufweist. Eine solche Zone bezeichnet man auch als Feldimplantation oder Felddiffusion. Sie dient dazu, das umdotierte Gebiet 5 in lateraler Richtung eindeutig zu begrenzen.

Das umdotierte Gebiet 5 stellt zusammen mit dem kontaktierenden Streifen 4 aus hochdotiertem, polykristallinem Silizium eine Doppelleitungsstruktur dar, deren ohmscher Widerstand wesentlich kleiner ist als der einer herkömmlichen Diffusionsleitung. Der Streifen 4 ist zweckmässigerweise über eine Anschlussleitung 7 (Fig. 1) mit einem Anschluss 8 verbunden.

In Fig. 3 sind vier auf einem monokristallinen Halbleiterkörper 9 integrierte, in einer Reihe angeordnete Ein-Transistor-Speicherzellen 10 bis 13 dargestellt. Jeder Zelle ist ein etwa rechteckförmiger Dünnschichtbereich (Gateoxidbereich) 141 bis 144 der den Halbleiterkörper 9 abdeckenden, elektrisch isolierenden Schicht 14 zugeordnet. Die oberen Enden der Bereiche 141 und 143 sind in der Breite reduziert und münden in ein streifenförmiges Kontaktloch 15, in dem die Schicht 14 bis auf die Grenzfläche des Halbleiterkörpers 9 weggeätzt ist. Die unteren, in der Breite ebenfalls abgesetzten Enden der Bereiche 142 und 144 münden in ein entsprechend ausgebildetes streifenförmiges Kontaktloch 16. Oberhalb der Kontaktlöcher 15 und 16 und der diese unmittelbar umgebenden Teile der Isolierschicht 14 sind Streifen 17 und 18 aus hochdotiertem, polykristallinen Silizium plaziert, die im Bereich der Kontaktlöcher 15 und 16 unmittelbar der Grenzfläche des Halbleiterkörpers 9 anliegen. Unterhalb der Kontaktlöcher 15 und 16 befinden sich entgegengesetzt zu 9 dotierte, streifenförmige Halbleitergebiete, die in Fig. 3 schraffiert angedeutet sind. Aus Gründen einer einfachen Darstellung fallen in Fig. 3 ihre lateralen Grenzen mit den Begrenzungen der Kontaktlöcher 15 und 16 zusammen.

Zwischen den als Bitleitungen dienenden Leitungsstrukturen 15, 17 und 16, 18, die entsprechend den Figuren 1 und 2 ausgebildet sind, ist eine breite Belegung 19 auf der isolierenden Schicht 14 aufgebracht, die aus hochdotiertem, polykristallinem Silizium besteht. Diese definiert innerhalb der einzelnen Gateoxidbereiche 141 bis 144 jeweils Speicherelektroden, die Bestandteile von Speicherkondensatoren sind. Einer der Speicherkondensatoren ist in Fig. 3 mit 20 bezeichnet und schraffiert dargestellt. Ein dem Kondensator 20 benachbarter Bereich 21, der in Fig. 3 ebenfalls schraffiert ist, stellt einen Transferkanal dar, über den Ladungsträger aus der als Bitleitung dienenden Leitungsstruktur 16, 18 in den Kondensator 20 gelangen und umgekehrt. Der Transferkanal wird von einem Transfergate überdeckt, das aus einer weiteren, gegenüber den Streifen 17, 18 und der Belegung 19 isoliert aufgebrachten, elektrisch leitenden Regelung besteht, die ebenfalls aus hochdotiertem, polykristallinen Silizium gebildet ist. Wegen der besseren Übersicht ist diese Belegung nur für die Speicherzellen 10 und 11 dargestellt und in ihren lateralen Abmessungen durch die strichpunktierte Linie 22 gekennzeichnet. Von der Belegung 22 wirken jeweils nur diejenigen Teile als Transfergate-Elektroden, die oberhalb der der Fläche 21 entsprechenden Zonen der einzelnen Speicherzellen liegen. Die zu den Speicherzellen 10 und 11 gehörigen Transfergate-Elektroden werden über eine Wortleitung 23 angesteuert, die über einer die Belegung 22 abdeckenden Isolierschicht verlegt ist und durch ein in dieser vorgesehenes Kontaktloch 24 die Belegung 22 kontaktiert. Die Bitleitungen 15, 17 und 16, 18 sind über Verbindungsleitungen mit Lese- und Regenerierverstärkern 25 und 26 beschaltet, die zum Auslesen und Regenerieren von in den Speicherzellen enthaltenen Informationen sowie zum Wiedereinlesen der regenerierten Informationen dienen. Zum Einlesen von Informationen dienen im übrigen weitere Anschlüsse 27 und 28 der Bitleitungen 15, 17 und 16, 18.

Die Belegung 19 ist schliesslich über einen Anschluss 29 an ein vorgegebenes Potential geschaltet, das unterhalb der Bereiche 141 bis 144 Raumladungszonen entstehen lässt, in die in an sich bekannter Weise im leitenden Zustand der jeweils zugeordneten Transferkanäle aus der Bitleitung stammende Ladungsträger eindringen, so dass sich Inversionsrandschichten bilden.

Wegen des niedrigen ohmschen Widerstandes der Bitleitungsstrukturen 17 und 18 ist die Laufzeit der die Informationen darstellenden elektrischen Signale von den einzelnen Speicherzellen 10 bis 13 zum Lese- und Regenerierverstärker 25 bzw. 26 so klein, dass sie im Verhältnis zu anderen, für die Zugriffszeit eines Speichers relevanten Vorgängen nicht ins Gewicht fällt. Die Transfergateelektroden, die aus den Teilen der Belegung 22 bestehen, die sich oberhalb der Bereiche 21 der einzelnen Bereiche 141 bis 144 befinden, füllen den Raum zwischen den Streifen 17 und 18 einerseits und den Randzonen der Belegung 19 andererseits so aus, dass sie gegenüber diesen Teilen selbstjustierend sind. Es können also zwischen den Transfergateelektroden und den Teilen 17, 18 und 19 keine Spalte auftreten, deren Grösse durch die Justiergenauigkeit von Masken od. dgl. beeinflusst werden könnte.

Bei der Herstellung einer niederohmigen Leitung nach den Figuren 1 und 2 wird so vorgegangen, dass ein dotierter Halbleiterkörper 1 an einer Grenzfläche mit einer elektrisch isolierenden Schicht 2 bedeckt wird. Diese Schicht 2 wird mit einem streifenförmigen Kontaktloch 3 versehen, in dessen Bereich das Material der Schicht bis auf die Grenzfläche des Halbleiterkörpers entfernt wird. Anschliessend wird eine insbesondere ganzflächige Belegung aus polykristallinem Silizium aufgebracht, die innerhalb des Kontaktloches 3 der Grenzfläche des Halbleiterkörpers 1 unmittelbar anliegt. In einem nachfolgenden Dotierungsvorgang, also einer Diffusion oder Implantation von Dotierungsstoffen, wird die erforderliche Dotierung der polykristallinen Belegung eingestellt. Gleichzeitig gelangen aber die verwendeten Dotierungsstoffe im Bereich des Kontaktloches 3 durch die Belegung hindurch in eine Zone des Halbleiterkörpers, die hierdurch umdotiert wird, so dass ein entgegengesetzt dotiertes Gebiet 5 entsteht, das von der Berührungsfläche der polykristallinen Belegung und des Halbleiterkörpers 1 ausgeht. Schliesslich wird durch an sich bekannte fotolithographische Schritte der Streifen 4 (Fig. 1) durch Wegätzen der nicht benötigten Teile der Belegung gebildet. Beim Anwachsen der in den Bereich 5 eindringenden Menge von Dotierungsstoffen wird dessen untere Grenze in das Innere des Halbleiterkörpers 1 vorgeschoben, so dass der Bereich 5 einen grösseren Querschnitt erhält und damit niederohmiger wird. Bei diesem Herstellungsverfahren ist es nun ein grosser Vorteil, dass die Dotierung der polykristallinen Belegung ohne Schwierigkeiten so stark dimensioniert werden kann, dass die Zone 5 hinreichend niederohmig wird. Andere Umdotierungsgebiete des Halbleiterkörpers 1 werden mit diesem Dotierungsvorgang nicht erzeugt, so dass er auch nicht wegen ggf. gewünschter kleinerer Abmessungen anderer Umdotierungsgebiete abgebrochen werden müsste.

Der in Fig. 3 dargestellte Halbleiterspeicher wird prinzipiell in folgender Weise gefertigt: Der dotierte Halbleiterkörper 9 wird an einer Grenzfläche zunächst mit einer elektrisch isolierenden Schicht 14 versehen, die Dünnschichtbereiche 141 bis 144 aufweist, während sie ausserhalb derselben als eine Dickschicht (Feldoxidschicht) ausgebildet ist. In der Schicht 14 werden streifenförmige Kontaktlöcher 15 und 16 vorgesehen. Anschliessend wird eine insbesondere ganzflächige Belegung aus polykristallinem Silizium aufgebracht, die innerhalb der Kontaktlöcher 15 und 16 der Grenzfläche des Halbleiterkörpers 14 unmittelbar anliegt. In einem folgenden Dotierungsvorgang (Diffusion oder Implantation von Dotierungsstoffen) wird die erforderliche Dotierung der polykristallinen Belegung eingestellt. Gleichzeitig gelangen aber auch hier Dotierungsstoffe im Bereich der Kontaktlöcher 15 und 16 durch die Belegung hindurch in Zonen des Halbleiterkörpers 9, die hierdurch umdotiert werden. Damit entstehen unterhalb der Kontaktlöcher 15 und 16 entgegengesetzt zum Körper 9 dotierte Halbleitergebiete, die bei entsprechend starker Dotierung der Belegung einen grossen Querschnitt aufweisen und somit niederohmig sind. Es schliessen sich fotolithographische Schritte an, mit denen sowohl die Streifen 17 und 18 als auch die die Speicherelektroden bildende Belegung 19 durch Entfernung der nicht benötigten Teile der Belegung geformt werden. Die bisher erhaltene Struktur wird anschliessend mit einer weiteren elektrisch isolierenden Schicht, z.B. aus SiO$_2$, abgedeckt, über der eine weitere, insbesondere ganzflächige Belegung aus polykristallinem Silizium aufgebracht wird. Aus der letzteren werden nach einer vorausgehenden Dotierung durch weitere fotolithographische Schritte die einzelnen in Fig. 3 mit 22 gekennzeichneten Gatestrukturen gebildet, die sich selbstjustierend zwischen die Randzonen der Teile 17, 18 und 19 einfügen und diese zumindest randseitig überdecken. Eine zusätzlich aufgebrachte Isolierschicht, die die Strukturen 22 abdeckt, wird mit Kontaktlöchern 24 versehen, in denen darüber verlegte Wortleitungen 23, z.B. aus Aluminium, die Strukturen 22 kontaktieren. Schliesslich werden die Streifen 17, 18 und 19 mit Anschlussleitungen versehen.

### Patentansprüche

1. Niederohmige Leitung mit einem an der Grenzfläche eines dotierten Halbleiterkörpers (1) vorgesehenen, zu diesem entgegengesetzt dotierten streifenförmigen Gebiet (5), dadurch gekennzeichnet, dass oberhalb des Gebietes (5) ein dieses streifenförmige Gebiet (5) auf seine ganze Länge kontaktierender Streifen (4) aus hochdotiertem polykristallinem Silizium angeordnet ist, der zusammen mit dem streifenförmigen Gebiet (5) eine auf die ganze Streifenlänge kurzgeschlossene Doppelleitungsstruktur bildet.

2. Niederohmige Leitung nach Anspruch 1, dadurch gekennzeichnet, dass ein den kontaktierenden Streifen (18) zumindest randseitig überdeckendes, gegen die Grenzfläche und den kontaktierenden Streifen (18) elektrisch isoliertes Transfergate (22) vorgesehen ist.

3. Niederohmige Leitung nach einem der Ansprüche 1 oder 2, dadurch gekennzeichnet, dass sie als Bitleitung (17, 18) einer dynamischen Ein-Transistor-Speicherzelle (10 bis 13) ausgebildet ist.

4. Niederohmige Leitung nach Anspruch 3, dadurch gekennzeichnet, dass sie in einem vorgegebenen Abstand zu einer aus hochdotiertem, polykristallinem Silizium hergestellten Speicherelektrode (19) angeordnet ist und dass ein den kontaktierenden Streifen (18) und die Speicherelektrode (19) zumindest randseitig überdeckendes, gegen dieselben und die Grenzfläche des Halbleiterkörpers elektrisch isoliertes Transfergate (22) vorgesehen ist.

5. Verfahren zur Herstellung einer niederohmigen Leitung (4, 5) mit einem an der Grenzfläche eines dotierten Halbleiterkörpers (1) vorgesehenen, zu diesem entgegengesetzt dotierten, streifenförmigen Gebiet (5) und mit einem oberhalb des streifenförmigen Gebietes (5) angeordneten, dasselbe auf seine ganze Länge kontaktierenden Streifen (4) aus hochdotiertem polykristallinem Silizium, der zusammen mit dem streifenförmigen Gebiet (5) eine auf die ganze Streifenlänge kurzgeschlossene Doppelleitungsstruktur bildet, bei dem der dotierte Halbleiterkörper (1) an einer Grenzfläche mit einer elektrisch isolierenden Schicht (2) bedeckt wird, bei dem diese Schicht (2) mit einem streifenförmigen Kontaktloch versehen wird, bei dem auf der elektrisch isolierenden Schicht (2) eine Belegung aus polykristallinem Silizium aufgebracht wird, bei dem die Belegung einem Dotierungsvorgang ausgesetzt wird, wobei im Bereich des Kontaktloches Dotierungsstoffe durch die Belegung in den Halbleiterkörper eindringen und das zu diesem entgegengesetzt dotierte Gebiet (5) erzeugen, und bei dem aus der Belegung durch fotolithographische Schritte der das streifenförmige Gebiet (5) auf dessen ganze Länge kontaktierende Streifen (4) geformt wird.

6. Verfahren zur Herstellung einer als Bitleitung einer dynamischen Ein-Transistor-Speicherzelle (10) ausgebildeten, niederohmigen Leitung mit einem an der Grenzfläche eines dotierten Halbleiterkörpers (9) vorgesehenen, zu diesem entgegengesetzt dotierten, streifenförmigen Gebiet und mit einem oberhalb des streifenförmigen Gebietes angeordneten, dasselbe auf seine ganze Länge kontaktierenden Streifen (18) aus hochdotiertem polykristallinem Silizium, der zusammen mit dem streifenförmigen Gebiet eine auf die ganze Streifenlänge kurzgeschlossene Doppelleitungsstruktur bildet, wobei die niederohmige Leitung in einem vorgegebenen Abstand zu einer aus hochdotiertem, polykristallinem Silizium hergestellten Speicherelektrode (19) angeordnet ist und ein den kontaktierenden Streifen (18) und die Speicherelektrode (19) zumindest randseitig überdeckendes, gegen dieselben und die Grenzfläche des Halbleiterkörpers (9) elektrisch isoliertes Transfergate (22) vorgesehen ist, bei dem der dotierte Halbleiterkörper (9) an einer Grenzfläche mit einer elektrisch isolierenden Schicht (14) überdeckt wird, bei dem die elektrisch isolierende Schicht (14) in einen Dünnschichtbereich und einen Dickschichtbereich unterteilt und mit einem streifenförmigen Kontaktloch (16) versehen wird, bei dem auf der elektrisch isolierenden Schicht (14) eine Belegung aus polykristallinem Silizium aufgebracht wird, bei dem diese Belegung einem Dotierungsvorgang ausgesetzt wird, wobei im Bereich des Kontaktloches (16) Dotierungsstoffe durch die Belegung in den Halbleiterkörper (9) eindringen und das zu diesem entgegengesetzt dotierte, von dem kontaktierenden Streifen (18) auf seiner ganzen Länge kontaktierte Gebiet erzeugen, bei dem durch fotolithographische Schritte aus der Belegung einerseits der kontaktierende Streifen (18) und andererseits oberhalb eines Teiles des Dünnschichtbereiches die Speicherelektrode (19) gebildet werden, bei dem eine weitere elektrisch isolierende Schicht ganzflächig aufgebracht wird, bei dem auf dieser letzteren Schicht eine weitere Belegung aus polykristallinem Silizium aufgebracht wird, bei dem aus dieser Belegung durch weitere fotolithographische Schritte das Transfergate (22) gebildet wird, das die Speicherelektrode (19) und den kontaktierenden Streifen (18) wenigstens randseitig überdeckt, und bei dem das Transfergate (22), die Speicherelektrode (19) und die Bitleitung mit Anschlussleitungen verbunden werden.

**Claims**

1. A low-ohmic conductor comprising a strip-shaped zone (5) which is arranged at the boundary surface of a doped semiconductor body (1) and is doped oppositely to said semiconductor body, characterised in that above the zone (5) a strip (4) of highly doped polycrystalline silicon is arranged which contacts this strip-shaped zone (5) along its entire length and which, together with the strip-shaped zone (5), forms a double conductor structure short-circuited along the entire length of the strip.

2. A low-ohmic conductor as claimed in Claim 1, characterised in that a transfer gate (22) is provided which covers the contacting strip (18) at least at the edge and which is electrically insulated from the boundary surface and from the contacting strip (18).

3. A low-ohmic conductor as claimed in Claim 1 or 2, characterised in that it forms the bit line (17, 18) of a dynamic one-transistor storage cell (10 to 13).

4. A low-ohmic conductor as claimed in Claim 3, characterised in that it is arranged at a predetermined distance from a storage electrode (19) produced from highly doped, polycrystalline silicon, and that a transfer gate (22) is provided which covers the contacting strip (18) and the storage electrode (19) at least at the edge, and which is electrically insulated from these and from the boundary surface of the semiconductor body.

5. A process for the production of a low-ohmic conductor (4, 5) comprising a strip-shaped zone (5) which is arranged at the boundary surface of a doped semiconductor body (1) and is doped oppositely to said semiconductor body, and a strip (4) of highly-doped polycrystalline silicon which is arranged above the strip-shaped zone (5) which it contacts along its entire length, and which, together with the strip-shaped zone (5), forms a double line structure which is short-circuited along the entire length of the strip, wherein the doped semiconductor body (1) is covered at a boundary surface by an electrically insulating layer (2), wherein this layer (2) is provided with a strip-shaped contact hole, wherein a covering of polycrystalline silicon is applied to the electrically insulating layer (2), wherein the covering is subjected to a doping process, wherein, in the region of the contact hole, dopants penetrate through the covering into the semiconductor body and produce the zone (5) which is doped oppositely to said semiconductor body, and wherein, by the use of photolithographic steps, the strip (4) which contacts the strip-shaped zone (5) along its entire length is formed from the covering.

6. A process for the production of a low-ohmic conductor in the form of a bit line of a dynamic one-transistor storage cell (10), comprising a strip-shaped zone which is arranged at the boundary surface of a doped semiconductor body (9) and which is doped oppositely to said semiconductor body, and a strip (18) of highly doped polycrystalline silicon which is arranged above the strip-shaped zone which it contacts along its entire length, and which, together with the strip-shaped zone, forms a double line structure which is short-circuited along the entire length of the strip, wherein the low-ohmic conductor is arranged at a predetermined distance from a storage electrode (19) produced from highly doped, polycrystalline silicon, and a transfer gate (22) is provided which covers the contacting strip (18) and the storage electrode (19) at least at their edges and which is electrically insulated from these and from the boundary surface of the semiconductor body (9), wherein the doped semiconductor body (9) is covered at a boundary surface with an electrically insulating layer (14), wherein the electrically insulating layer (14) is divided into a thin-layer zone and a thick-layer zone and is provided with a strip-shaped contact hole (16), wherein a covering of polycrystalline silicon is applied to the electrically insulating layer (14), wherein this covering is subjected to a doping process in which, in the region of the contact hole (16), dopants penetrate through the covering into the semiconductor body and produce the zone which is doped oppositely to the semiconductor body and which is contacted by the contacting strip (18) along its entire length, wherein, by the use of photolithographic steps, there are formed from the covering, on the one hand, the contacting strip (18) and, on the other hand, above a part of the thin-layer zone, the storage electrode (19), wherein a further electrically insulating layer is applied to the entire surface, wherein a further covering of polycrystalline silicon is applied to this layer, wherein, by the use of further photolithographic steps, the transfer gate (22), which covers the storage electrode (19) and the contacting strip (18) at least at the edge, is formed from this covering, and wherein the transfer gate (22), the storage electrode (19) and the bit line are connected to connection lines.

**Revendications**

1. Conducteur faiblement ohmique avec une zone dopée (5) en forme de bande prévue à la surface-limite d'un corps semiconducteur dopé (1), les dopages de ladite zone et dudit corps semiconducteur étant contraires, caractérisé par le fait qu'au-dessus de ladite zone (5) est disposée une bande (4) en silicium polycristallin fortement dopé et contactant sur toute sa longueur ladite zone (5) en forme de bande, la bande (4) formant avec la zone (5) en forme de bande, une structure à double conducteurs court-circuitée sur toute la longueur de la bande.

2. Conducteur faiblement ohmique selon la revendication 1, caractérisé par le fait qu'il est prévu une grille de transfert (22) qui recouvre au moins sur le côté du bord la bande de contact (18) et qui est isolée électriquement par rapport à la surface-limite et par rapport à la bande de contact (18).

3. Conducteur faiblement ohmique selon l'une des revendications 1 ou 2, caractérisé par le fait qu'il est réalisé en tant que conducteur de bits (17, 18) d'une cellule de mémoire dynamique (10 à 13) à transistor unique.

4. Conducteur faiblement ohmique selon la revendication 3, caractérisé par le fait qu'il est disposé à une distance prédéterminée d'une électrode de mémoire (19) faite avec du silicium polycristallin et fortement dopée, et qu'il est prévu une grille de transfert (22) qui recouvre, au moins du côté du bord, la bande de contact (18) et l'électrode de mémoire (19) et qui est isolée électriquement par rapport à celles-ci et par rapport à la surface-limite du corps semiconducteur.

5. Procédé pour la fabrication d'un conducteur faiblement ohmique (4, 5) avec une zone dopée (5) en forme de bande, prévue à la surface-limite d'un corps semiconducteur dopé (1), les dopages de cette zone (5) et dudit corps semiconducteur étant contraires, et avec une bande (4) faite avec du silicium polycristallin qui est disposée au-dessus de la zone (5) en forme de bande et qui contacte sur toute sa longueur ladite zone (5), ladite bande (4) formant avec la zone (5) en forme de bande une structure à double conducteurs qui est court-circuitée sur toute la longueur de la bande, dans lequel le corps semiconducteur dopé (1) est recouvert sur une surface-limite, d'une couche (2) électriquement isolante, dans lequel cette couche (2) est pourvue d'un trou de contact en forme de bande, dans lequel on dépose sur la couche (2) électriquement isolante un revêtement en silicium polycristallin, dans lequel ledit revêtement est exposé à un processus de dopage, les substances de dopage pénétrant, au niveau du trou de contact et à travers le revêtement, dans le corps semiconducteur et produisant la zone dopée (5) du type opposé au dopage dudit corps semiconducteur, et dans lequel on forme, à partir du revêtement et par des phases opératoires de photolithographie, la bande (4) qui contacte la zone (5) en forme de bande sur toute sa longueur.

6. Procédé pour la fabrication d'un conducteur faiblement ohmique réalisé en tant que conducteur de bits d'une cellule de mémoire dynamique (10) à un seul transistor, avec une zone en forme de bande qui est prévue à la surface-limite d'un corps semiconducteur dopé, et dopée en sens contraire au dopage de ce corps, et avec une bande (18) faite avec du silicium polycristallin et qui est disposée au-dessus de la zone en forme de bande, en contactant celle-ci sur toute sa longueur, la bande (18) formant avec la zone en forme de bande une structure à conducteurs double qui est court-circuitée sur toute la longueur de la bande, le conducteur faiblement ohmique étant disposé à une distance prédéterminée par rapport à une électrode de mémoire (19) faite avec du silicium polycristallin fortement dopé et une grille de transfert (22) étant prévue, qui recouvre, au moins du côté du bord, la bande de contact (18) et l'électrode de mémoire (19), alors que ladite grille de transfert est électriquement isolée par rapport à la bande de contact, par rapport à l'électrode de mémoire (19) et par rapport à la surface-limite du corps semiconducteur (9), dans lequel le corps semiconducteur dopé (9) est recouvert, au niveau d'une surface-limite, d'une couche électriquement isolante (14), dans lequel la couche électriquement isolante (14) est subdivisée en une zone à couche mince et en une zone à couche épaisse et est pourvue d'un trou de contact (16) ayant la forme d'une bande, dans lequel on dépose, sur la couche électriquement isolante (14), un revêtement fait avec du silicium polycristallin, dans lequel le revêtement est soumis à un processus de dopage, les substances de dopage pénétrant, dans la zone du trou de contact (16) et à travers le revêtement, dans le corps semiconducteur (9) et produisent la zone dopée en sens contraire audit corps semiconducteur et contactée par la bande de contact (18) sur toute sa longueur, dans lequel et par des phases opératoires de photolithographie, on forme à partir du revêtement d'une part la bande de contact (18) et, d'autre part, au-dessus d'une partie de la zone en couche mince, l'électrode de mémoire (19), dans lequel on dépose, d'un seul tenant, une seconde couche électriquement isolante, dans lequel on dépose sur cette dernière couche un second revêtement en silicium polycristallin, dans lequel on forme, à partir de ce revêtement et par d'autres phases opératoires photolithographiques, la grille de transfert (22) qui recouvre au moins du côté du bord l'électrode de mémoire (19) et la bande de contact (18), et dans lequel la grille de transfert (22), l'électrode de mémoire (19) et le conducteur de bits sont reliés à des conducteurs de branchement.

# FIG 1

# FIG 2

# FIG 3